# EUROPEAN PATENT APPLICATION

(11) **EP 1 750 307 A2**
(43) Date of publication of application: **07.02.2007**
(21) Application number: 06015600.7
(22) Date of filing: 26.07.2006
(51) Int. Cl.: H01L 25/075, H01L 33/00

(54) **Edge-emitting LED light source**

(30) Priority: 04.08.2005 US 197010
(71) Applicant: Avago Technologies ECBU IP (Singapore) Pte. Ltd., Singapore 768923 (SG)
(72) Inventor: Lester, Steven D., Loveland, CO 80537-0599 (US); Robbins, Virginia M., Loveland, CO 80537-0599 (US); Miller, Jeffrey N., Loveland, CO 80537-0599 (US); Corzine, Scott W., Loveland, CO 80537-0599 (US)
(74) Representative: Schoppe, Fritz

(57) **Abstract**

Edge-emitting LED light source, and method for fabricating an edge-emitting LED light source. The edge-emitting LED light source has a plurality of edge-emitting LEDs (202, 204, 206, 302, 304, 306, 402, 404, 406) arranged in close proximity to one another to define an array of edge-emitting LEDs (210, 310, 410). Light beams (232, 234, 236) separately emitted by each of the plurality of edge-emitting LEDs in the array together form a single light beam (240, 340, 440, 540) that has a generally two-dimensional cross-sectional shape, for example, a square or other rectangular shape, and an increased overall light flux.

## Description

### DESCRIPTION OF RELATED ART

Conventional light-emitting diodes (LEDs) are not sufficiently bright (i.e. do not generate sufficient light/unit area/unit angle), and do not have sufficient light flux (time rate of flow of energy) to be used in many applications. An edge-emitting LED, on the other hand, can provide a relatively bright light source. For example, GaN (Gallium Nitride)-based edge-emitting LEDs such as edge-emitting LEDs based on AIGaInN or InGaN, can provide a very bright blue or green light beam.

Edge-emitting LEDs, however, are essentially line light sources in that they emit a light beam having a very narrow elongated cross-sectional shape; and, as a result, are also not suitable for use in many applications. For example, applications such as imaging onto a spatial light modulator or coupling into an optical fiber require a light source that emits a light beam having a more two-dimensional cross-sectional shape than can be provided by an edge-emitting LED.

### SUMMARY OF THE INVENTION

In accordance with the invention, an edge-emitting LED light source and a method for fabricating an edge-emitting LED light source are provided. The edge-emitting LED light source has a plurality of edge-emitting LEDs arranged in close proximity to one another to define an array of edge-emitting LEDs. Light beams separately emitted by each of the plurality of edge-emitting LEDs in the array together form a single light beam that has a generally two-dimensional cross-sectional shape, for example, a square or other rectangular shape, and an increased overall light flux. The edge-emitting LED light source can be effectively used for imaging onto a light modulator, for coupling into an optical fiber and for other applications requiring a light source.

### BRIEF DESCRIPTION OF THE DRAWINGS

Furthermore, the invention provides embodiments and other features and advantages in addition to or in lieu of those discussed above. Many of these features and advantages are apparent from the description below with reference to the following drawings.
**FIG. 1** is a schematic plan view of an edge-emitting LED that is known in the art to assist in explaining embodiments in accordance with the invention;
**FIG. 2** is a schematic side view of an edge-emitting LED light source according to an exemplary embodiment in accordance with the invention;
**FIG. 3** is a schematic plan view of an edge-emitting LED light source according to a further exemplary embodiment in accordance with the invention;
**FIG. 4** is a schematic plan view of an edge-emitting LED light source according to a further exemplary embodiment in accordance with the invention;
**FIG. 5** is a schematic plan view of an edge-emitting LED light source according to a further exemplary embodiment in accordance with the invention; and
**FIG. 6** is a flowchart that illustrates a method for fabricating an edge-emitting LED light source according to an exemplary embodiment in accordance with the invention.

### DETAILED DESCRIPTION OF THE EXEMPLARY EMBODIMENTS OF THE INVENTION

Exemplary embodiments in accordance with the invention provide an edge-emitting light-emitting diode (LED) light source and a method for fabricating an edge-emitting LED light source.

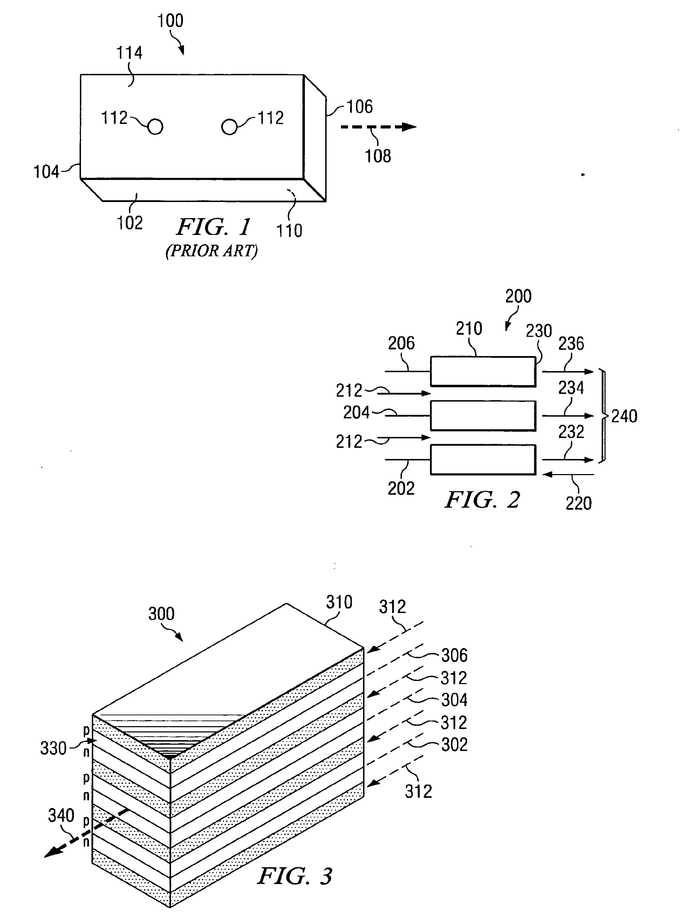

**FIG. 1** is a schematic plan view of an edge-emitting LED that is known in the art to assist in explaining embodiments in accordance with the invention. The edge-emitting LED is generally designated by reference number **100**, and comprises a GaN (Gallium Nitride)-based edge-emitting LED, specifically, an AlGaInN-based edge-emitting LED. GaN-based edge-emitting LEDs are preferable over conventional surface-emitting LEDs in many applications because they can provide a very bright blue or green light beam.

Edge-emitting LED **100** includes a sapphire (Al₂O₃) substrate **102** and GaN-based epitaxial layers **104.** As is known to those skilled in the art, much of the light produced by LED **100** (~70 percent of the light) is trapped between substrate **102** and epitaxial layers **104**, and is guided to the edges of the LED. Reflectors (not shown in **FIG. 1**) are usually provided on non-light emitting edge **110** of LED **100** to redirect light guided to edge **110** to light-emitting edge **106** such that a bright blue or green light beam **108** is emitted from light-emitting edge **106.**

Two contacts, schematically illustrated at **112,** are typically provided on top surface **114** of epitaxial layers **104** to provide electrical connection for the LED.

GaN-based edge-emitting LED **100** emits a light beam having a very narrow elongated cross-sectional shape, for example, a beam that is about 500 microns wide and about 4 microns thick. As a result, edge-emitting LED **100** is essentially a line light source and is not suitable for use in applications that desire a light beam having a more two-dimensional cross-sectional shape, such as a square or other rectangular shape. Thus, although a GaN-based edge-emitting LED is a bright light source; its usefulness is severely restricted by the shape of the light beam it emits.

**FIG. 2** is a schematic side view of an edge-emitting LED light source according to an exemplary embodiment in accordance with the invention. The light source is generally designated by reference number **200,** and comprises a plurality of edge-emitting LEDs arranged in close proximity to one another to define an array of edge-emitting LEDs. In the exemplary embodiment in accordance with the invention illustrated in **FIG. 2,** light source **200** comprises three edge-emitting LEDs **202, 204** and **206** arranged one above the other to define an array **210** comprising a vertical stack of edge-emitting LEDs that are spaced from one another by narrow gaps **212.** As will become apparent hereinafter, however, array 210 illustrated in **FIG. 2** is intended to be exemplary only as edge-emitting LED light sources according to the invention can comprise any desired plurality of edge-emitting LEDs arranged in an array of any desired configuration.

According to an exemplary embodiment in accordance with the invention, edge-emitting LEDs **202, 204** and **206** comprise GaN-based edge-emitting LEDs, for example, AlGaInN-based edge-emitting LEDs such as illustrated in **FIG. 1.** GaN-based edge-emitting LEDs are desirable light sources in many applications because they emit a bright blue or green light beam. It should be understood, however, that the invention is not limited to an edge-emitting LED of any particular type or to an edge-emitting LED that emits light of any particular color.

Edge-emitting LEDs **202, 204** and **206** are preferably spaced from one another by a distance of from about 1 to about 50 microns. The spacing should be sufficient to enable each LED to be electrically connected to an external source via contacts thereon (e.g., contacts **112** illustrated in **Figure 1**), but small enough such that the light beam emitted by light source **200** will be as bright as desired (in general, the closer LEDs **202, 204** and **206** are to one another, the brighter the light beam emitted by light source **200**).

As shown in **FIG. 2,** edge-emitting LEDs **202, 204** and **206** emit separate light beams **232, 234** and **236,** respectively, from light-emitting edge **230** of light source **200,** each light beam having an elongated, narrow cross-sectional shape typical of an edge-emitting LED. The individual light beams are substantially parallel to one another and will diverge as they leave the LEDs. Because of the close proximity of LEDs **202, 204** and **206** to one another, the individual beams will blend together at a modest distance from the LEDs to define a single, uniform light beam **240** that has a generally two-dimensional cross-sectional shape, such as a square or other rectangular shape, and that has an increased overall light flux. As a result, edge-emitting LED light source **200** comprises a bright, substantially rectangular two-dimensional edge-emitting LED light source that can be effectively used in applications that require or desire a two-dimensional light source.

The plurality of closely spaced edge-emitting LEDs can be packaged together in various ways to provide light source **200.** For example, a stack of LEDs such as illustrated in **FIG. 2,** or a two-dimensional array of LEDs, as will be described hereinafter, can be affixed to a heat sink. An array of LEDs can also be placed in a reflective cavity, or cup, in order to redirect any light that may be emitted by the LEDs in directions other than the desired direction.

**FIG. 3** is a schematic plan view of an edge-emitting LED light source according to a further exemplary embodiment in accordance with the invention. The light source is generally designated by reference number **300,** and similar to edge-emitting LED light source **200** illustrated in **FIG. 2,** includes three edge-emitting LEDs **302, 304** and **306** arranged one above the other to define an array **310** comprising a vertical stack of edge-emitting LEDs. Edge-emitting LED light source **300** differs from edge-emitting LED light source **200** in that instead of providing a narrow gap **212** between each edge-emitting LED as in light source **200,** light source 300 includes a contact member **312** between each edge-emitting LED **302, 304** and **306** for electrically coupling the plurality of LEDs. In the exemplary embodiment in accordance with the invention illustrated in **FIG. 3,** contacts **312** comprise thin layers of silver, although contact members formed of other materials such as, for example, contact members having aluminum on one side and gold on the opposite side may also be used if desired.

Contact members **312** are positioned between each edge-emitting LED **302, 304** and **306** to effectively and compactly electrically couple the plurality of LEDs in series via contacts on the LEDs. (In the exemplary embodiment in accordance with the invention illustrated in **FIG. 3,** a single contact is provided on each side of the LEDs to make electrical contact with the silver layers.) In addition, silver contact members **312** are provided on the bottom surface of bottom LED **202** and on the top surface of top LED **206** to provide electrical connection to an external source. In a manner similar to edge-emitting LED light source **200,** individual edge-emitting LEDs **302, 304** and **306** in edge-emitting LED light source **300** will emit separate, closely spaced light beams from light-emitting edge **330** of light source **300** that have a narrow elongated cross-sectional shape, but that blend together to form a single light beam **340** that has a generally two-dimensional cross-sectional shape, such as a square or other rectangular shape, and that has an increased overall light flux.

As illustrated in **FIG. 3,** forming contact members **312** of silver provides the advantage that the contact members can serve as a p-contact for some of the LEDs and as an n-contact for others of the LEDs. In addition, silver contact members provide the further advantages of being able to effectively remove heat from LED light source 300, and of being a good reflector so they will will not absorb stray light from the light source. According to exemplary embodiments in accordance with the invention, silver contact members **312** have a thickness of from about 1µ to a few 10's of microns, for example, about 10-20µ. In general, the thinner the silver contact members, the closer LEDs **302, 304** and **306** will be to one another and the brighter the light beam that will be emitted by light source **300.** On the other hand, thicker silver contact members will be able to remove more heat from the light source. Thus, thicker silver contact members are provided when increased heat removal is desired, and thinner contact members are provided when a brighter light source is desired.

Light source **300** can be fabricated by simply positioning LEDs **302, 304** and **306** one above the other with silver contact members between the LEDs and above and below the stack of LEDs. The stack of LEDs can be bonded together, for example, by melting the silver contact members onto the surfaces of the LEDs.

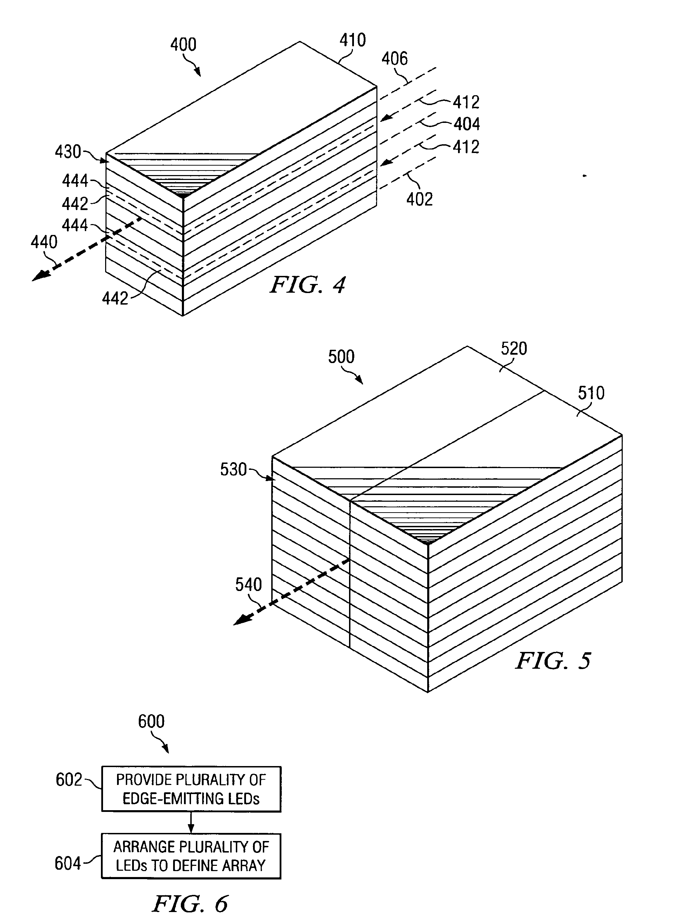

**FIG. 4** is a schematic plan view of an edge-emitting LED light source according to a further exemplary embodiment in accordance with the invention. The edge-emitting LED light source is generally designated by reference number **400,** and, similar to edge-emitting LED light source **300** in **FIG. 3,** includes an array **410** of edge-emitting LEDs **402, 404** and **406** arranged as a vertical stack of LEDs. Also similar to edge-emitting light source **300,** individual edge-emitting LEDs **402, 404** and **406** will emit separate closely spaced light beams from light-emitting edge **430** of light source **400** that have a narrow elongated cross-sectional shape, but that blend together to define a single light beam **440** that has a generally two-dimensional cross-sectional shape, such as a square or other rectangular shape, and that has an increased overall light flux.

Edge-emitting LED light source **400** differs from edge-emitting LED light source **300** in that the plurality of silver contact members **312** in light source **300** are replaced by a plurality of tunnel junctions **412.** Specifically, the plurality of edge-emitting LEDs are stacked in a series array using tunnel junctions **412** formed within the epitaxial layers of the LEDs.

In an exemplary embodiment in accordance with the invention wherein edge-emitting LEDs **402, 404** and **406** comprise GaN-based edge-emitting LEDs, tunnel junctions 412 each comprise p++ AlGaInN layer **442** and n++ AIGaInN layer **444.** Layer **442** is heavily p doped, for example, with magnesium, to a concentration in the range from about 6· 10¹⁹/cm³ to about 1· 10²⁰/cm³. Layer **444** is heavily n doped, typically with silicon, to a concentration much greater than 1· 10²⁰/cm³, for example, in the range of from about 2· 10²⁰/cm³ to about 3. 10²⁰/cm³.

In the exemplary embodiments illustrated in **Figures 2-4,** edge-emitting LED light sources **200-400** each comprises an array in the form of a vertical stack of individual edge-emitting LEDs. Such a stack will provide a light beam of generally rectangular-shaped cross-section having a width corresponding to the width of each LED and a height that is a function of the number of LEDs in the stack. For example, a light source composed of three closely-spaced edge-emitting LEDs will emit a light beam having a cross-sectional shape that is about 200-500 microns wide and about 0.1 microns high, and that will look like one continuous light souce. In accordance with the invention, however, edge-emitting LED light soutces can be fabricated to have a plurality of edge-emitting LEDs arranged in arrays having different configurations in order to provide a light beam having any desired two-dimensional cross-sectional shape.

**FIG. 5** is a schematic plan view of an edge-emitting LED light source according to a further exemplary embodiment in accordance with the invention. The light source is generally designated by reference number 500 and comprises two stacks **510** and **520** of edge-emitting LEDs arranged one above the other, for example, one of stacks **210, 310** or **410** illustrated in **FIGS. 2-4.** Stacks **510** and **520** are positioned side-by-side in close proximity to one another to provide light beam **540** emitted from light-emitting edge **530** of light source **500** that has a height corresponding to the number of edge-emitting LEDs in the stacks and a width corresponding to the combined width of the two stacks of edge-emitting LEDs.

Edge-emitting LED light source **500** can be useful in applications that desire a light beam having substantially the same cross-sectional shape as a display such as a CRT screen or the like. In general, an edge-emitting LED light source according to the invention can be constructed to include any desired number of stacks of individual edge-emitting LEDs arranged side-by-side or in any other configuration. For example, edge-emitting LEDs can also be arranged as one or more horizontal rows if desired.

**FIG. 6** is a flowchart that illustrates a method for fabricating an edge-emitting LED light source according to an exemplary embodiment in accordance with the invention. The method is generally designated by reference number **600** and begins by providing a plurality of edge-emitting LEDs (Step **602).** The plurality of edge-emitting LEDs are then arranged in close proximity to one another to define an array of edge-emitting LEDs wherein light beams separately emitted by each of the plurality of edge-emitting LEDs in the array together form a single light beam that has a generally two-dimensional cross-sectional shape (Step **604**).

While what has been described constitute exemplary embodiments in accordance with the invention, it should be recognized that the invention can be varied in numerous ways without departing from the scope thereof. Because exemplary embodiments in accordance with the invention can be varied in numerous ways, it should be understood that the invention should be limited only insofar as is required by the scope of the following claims.

## Claims

1. A light source, comprising:
a plurality of edge-emitting LEDs (202, 204, 206, 302, 304, 306, 402, 404, 406) arranged in close proximity to one another to define an array of edge-emitting LEDs (210, 310, 410), wherein light beams (232, 234, 236) separately emitted by each of the plurality of edge-emitting LEDs in the array together form a single light beam (240, 340, 440, 540) that has a generally two-dimensional cross-sectional shape.

2. The light source according to claim 1, wherein the plurality of edge-emitting LEDs (202, 204, 206, 302, 304, 306, 402, 404, 406) are arranged to define at least one stack of edge-emitting LEDs.

3. The light source according to claim 2, and further including one of a gap (212) between each edge-emitting LED (202, 204, 206) in the at least one stack of edge-emitting LEDs, a contact member (312) between each edge-emitting LED (302, 304, 306) in the at least one stack of edge-emitting LEDs for electrically connecting the plurality of LEDs in the at least one stack in series, and a tunnel junction (412) between each edge-emitting LED (402, 404, 406) in the at least one stack of edge-emitting LEDs.

4. The light source according to claim 3, wherein the gap (212) has a width of from about 1 micron to about 50 microns.

5. The light source according to claim 3, wherein the contact member (312) comprises a silver contact member (312).

6. The light source according to claim 2, and further including a contact member (312) on each of opposite sides of the at least one stack of edge-emitting LEDs (302, 304, 306) for electrically connecting the light source to a power source.

7. The light source according to claim 1, wherein the plurality of edge-emitting LEDs (202, 204, 206, 302, 304, 306, 402, 404, 406) comprise a plurality of GaN-based edge-emitting LEDs (202, 204, 206, 302, 304, 306, 402, 404, 406).

8. A method for fabricating an edge-emitting LED light source, comprising:
arranging a plurality of edge-emitting LEDs (202, 204, 206, 302, 304, 306, 402, 404, 406) in close proximity to one another to define an array of edge-emitting LEDs, (210, 310, 410) wherein light beams (232, 234, 236) separately emitted by each of the plurality of edge-emitting LEDs in the array (210, 310, 410) together form a single light beam (240, 340, 440, 540) that has a generally two-dimensional cross-sectional shape.

9. The method according to claim 8, wherein arranging a plurality of edge-emitting LEDs (202, 204, 206, 302, 304, 306, 402, 404, 406) in close proximity to one another to define an array of edge-emitting LEDs (210, 310, 410) comprises arranging the plurality of edge-emitting LEDs (202, 204, 206, 302, 304, 306, 402, 404, 406) to define at least one stack of edge-emitting LEDs.

10. The method according to claim 9, and further comprising:
providing one of a gap (212) between each edge-emitting LED (202, 204, 206) in the at least one stack, a contact member (312) between each edge-emitting LED (302, 304, 306) in the at least one stack for electrically connecting each edge-emitting LED in the at least one stack in series, and a tunnel junction (412) between each edge-emitting LED (402, 404, 406) in the at least one stack.
